# EUROPÄISCHE PATENTSCHRIFT

(11) **EP 4 067 890 B1**
(45) Veröffentlichungstag und Bekanntmachung des Hinweises auf die Patenterteilung: **07.05.2025**
(21) Anmeldenummer: 22161364.9
(22) Anmeldetag: 10.03.2022
(51) Int. Cl.: G01N 27/12, G08B 21/20, H02H 5/08

(54) **DETEKTION VON FEUCHTIGKEIT IN EINEM ELEKTRONISCHEN SCHALTKREIS**
DETECTION OF MOISTURE IN AN ELECTRONIC CIRCUIT
DÉTECTION DE L'HUMIDITÉ DANS UN CIRCUIT ÉLECTRONIQUE

(30) Priorität: 30.03.2021 CN 202110340992
(43) Veröffentlichungstag der Anmeldung: 05.10.2022
(73) Patentinhaber: Einhell Electro Machinery Technology Co., Ltd., Kunshan City, Jiangsu (CN)
(72) Erfinder: THANNHUBER, Markus, 94405 Landau (DE)
(74) Vertreter: Hofstetter, Schurack & Partner

(56) Entgegenhaltungen:
- EP-A1- 3 315 955
- US-A1- 2015 346 127
- US-A1- 2016 327 502
- US-A1- 2017 288 451

## Beschreibung

Die vorliegende Erfindung betrifft einen elektronischen Schaltkreis mit einer Feuchtigkeitsdetektionsvorrichtung, einem Akkupack zur Versorgung eines Elektrogeräts mit einem solchen elektronischen Schaltkreis, ein Elektrogerät mit einem solchen elektronischen Schaltkreis oder Akkupack sowie ein Verfahren zur Detektion von Feuchtigkeit in einem elektronischen Schaltkreis. US 2015/346127 A1 beschreibt einen Feuchtigkeitssensor.

In einen elektronischen Schaltkreis eindringende Feuchtigkeit kann zu Fehlfunktionen und Beschädigungen des elektronischen Schaltkreises beziehungsweise eines Geräts, das den elektronischen Schaltkreis beinhaltet, führen. Besonders dramatische Auswirkungen kann dies haben, wenn beispielhafte beschädigte Lithium-Ionen-Akkumulatorzellen mit Wasser in Berührung kommen, was zu einer heftigen Reaktion und in der Folge auch zu Personenschäden führen kann.

Es ist eine Aufgabe der vorliegenden Erfindung, eine einfache und zuverlässige Detektion von Feuchtigkeit in einem elektronischen Schaltkreis zu ermöglichen.

Diese Aufgabe wird gelöst durch den jeweiligen Gegenstand der unabhängigen Ansprüche. Vorteilhafte Weiterbildungen und bevorzugte Ausführungsformen sind Gegenstand der abhängigen Ansprüche.

Die Erfindung beruht auf der Idee, zusätzlich zu zwei Referenzstrukturen, die mit entsprechenden Referenzpotentialanschlüssen des elektrischen Schaltkreises verbunden sind, eine Detektionsstruktur vorzusehen und eine Spannung zwischen der Detektionsstruktur und einer der Referenzstrukturen zu messen, um eine Feuchtigkeit zwischen der Detektionsstruktur und der anderen Referenzstruktur zu detektieren.

Gemäß einem Aspekt der Erfindung wird ein elektronischer Schaltkreis mit einer Feuchtigkeitsdetektionsvorrichtung angegeben. Die Feuchtigkeitsdetektionsvorrichtung weist eine elektrisch leitfähige Detektionsstruktur auf, die in einer Umgebung einer elektrisch leitfähigen ersten Referenzstruktur des elektronischen Schaltkreises angeordnet ist, wobei die erste Referenzstruktur mit einem ersten Referenzpotentialanschluss des elektronischen Schaltkreises verbunden ist. Die Feuchtigkeitsdetektionsvorrichtung weist einen Spannungssensor auf, der einen ersten Sensoranschluss aufweist, welcher mit der Detektionsstruktur verbunden ist, sowie einen zweiten Sensoranschluss, der mit einer elektrisch leitfähigen zweiten Referenzstruktur des elektronischen Schaltkreises verbindbar ist. Die zweite Referenzstruktur ist dabei mit einem zweiten Referenzpotentialanschluss des elektronischen Schaltkreises verbunden. Der Spannungssensor ist dazu eingerichtet, ein Sensorsignal abhängig von einer elektrischen Spannung zwischen dem ersten Sensoranschluss und dem zweiten Sensoranschluss zu erzeugen. Die Feuchtigkeitsdetektionsvorrichtung weist eine Schaltvorrichtung auf, die dazu eingerichtet ist, den zweiten Sensoranschluss wahlweise von der zweiten Referenzstruktur zu trennen und mit der zweiten Referenzstruktur zu verbinden. Mit anderen Worten ist die Schaltvorrichtung dazu eingerichtet, den zweiten Sensoranschluss schaltbar mit der zweiten Referenzstruktur zu verbinden beziehungsweise den zweiten Sensoranschluss mit der zweiten Referenzstruktur zu verbinden sowie die Verbindung zu trennen. Die Feuchtigkeitsdetektionsvorrichtung weist eine Auswerteeinheit auf, die dazu eingerichtet ist, abhängig von dem Sensorsignal, das insbesondere erzeugt wird, während der zweite Sensoranschluss elektrisch mit der zweiten Referenzstruktur durch die Schaltvorrichtung verbunden ist, Feuchtigkeit zu detektieren, welche die erste Referenzstruktur mit der Detektionsstruktur elektrisch koppelt.

Der erste und der zweite Referenzpotentialanschluss liegen insbesondere auf unterschiedlichen elektrischen Potentialen. Der erste und der zweite Referenzpotentialanschluss des elektronischen Schaltkreises können beispielsweise zum Anschluss des elektronischen Schaltkreises an eine Spannungsquelle, beispielsweise eine oder mehrere Akkumulatorzellen, dienen. Alternativ kann der erste Referenzpotentialanschluss mit einer Versorgungsspannung für den elektronischen Schaltkreis verbunden werden und der zweite Referenzpotentialanschluss mit einem Masseanschluss oder umgekehrt. Die erste Referenzstruktur ist elektrisch direkt oder indirekt mit dem ersten Referenzpotentialanschluss verbunden, ebenso wie die zweite Referenzstruktur elektrisch direkt oder indirekt mit dem zweiten Referenzpotentialanschluss verbunden ist. Bei den Referenzstrukturen kann es sich beispielsweise um Drahtverbindungen, Leiterbahnen, Anschlüsse oder Pins von elektronischen Komponenten, Elektroden und so weiter handeln. Durch die direkte oder indirekte Verbindung der jeweiligen Referenzstrukturen mit dem entsprechenden Referenzpotentialanschluss ist insbesondere gewährleistet, dass die Referenzstrukturen jeweils auf einem definierten elektrischen Potential liegen.

Bei der Detektionsstruktur kann es sich beispielsweise ebenfalls um eine Leiterbahn, eine Drahtstruktur oder eine sonstige elektrisch leitfähige Struktur handeln, die insbesondere abgesehen von der Feuchtigkeitsdetektion für die Funktionalität des elektronischen Schaltkreises keine Bedeutung hat. Insbesondere ist die Detektionsstruktur im trockenen Zustand des elektronischen Schaltkreises, also wenn keine Feuchtigkeit die Detektionsstruktur mit der ersten oder der zweiten Referenzstruktur koppelt, und der zweite Sensoranschluss von der zweiten Referenzstruktur getrennt ist weder direkt noch indirekt mit einem der Referenzpotentialanschlüsse verbunden. Das elektrische Potential der Detektionsstruktur ist daher im Allgemeinen nicht festgelegt beziehungsweise schwebend.

Das Sensorsignal ist insbesondere ein direktes Maß für die Spannung zwischen dem ersten und dem zweiten Sensoranschluss. Verbindet die Schaltvorrichtung also den zweiten Sensoranschluss elektrisch mit der zweiten Referenzstruktur, so ist das Sensorsignal ein direktes Maß für die Spannung zwischen Detektionsstruktur und zweiter Referenzstruktur.

Dass die Feuchtigkeit die erste Referenzstruktur mit der Detektionsstruktur elektrisch koppelt, kann insbesondere derart verstanden werden, dass die Feuchtigkeit zumindest vorübergehend eine elektrische Verbindung zwischen der ersten Referenzstruktur und der Detektionsstruktur herstellt.

Aufgrund des schwebenden elektrischen Potentials der Detektionsstruktur im trockenen Zustand des Schaltkreises, liegt zum Zeitpunkt der elektrischen Verbindung der Detektionsstruktur mit der zweiten Referenzstruktur durch die Schaltvorrichtung eine elektrische Spannung zwischen den Sensoranschlüssen an, deren Betrag im Allgemeinen unbekannt ist. Da der Spannungssensor jedoch gezwungenermaßen einen endlichen Innenwiderstand aufweist, findet bei andauernder elektrischer Verbindung ein Ladungsausgleich zwischen Detektionsstruktur und zweiter Referenzstruktur statt. Dies führt dazu, dass nach einer charakteristischen Zeit die Spannung zwischen den Sensoranschlüssen auf einen vorgebbaren Wert abgefallen ist. Vereinfacht ausgedrückt fällt die Spannung zwischen den Sensoranschlüssen innerhalb einer bestimmten Zeit auf null oder im Wesentlichen auf null ab.

Anders stellt sich die Situation jedoch dar, wenn die Feuchtigkeit die Detektionsstruktur mit der ersten Referenzstruktur koppelt. In diesem Fall erhält die Detektionsstruktur von der ersten Referenzstruktur eine mehr oder weniger definierte elektrische Potentiallage. Mit anderen Worten lädt die erste Referenzstruktur die Detektionsstruktur nach, wenn Ladungen von der Detektionsstruktur über den Spannungssensor zu der zweiten Referenzstruktur fließen beziehungsweise umgekehrt. Dies führt dazu, dass die Spannung zwischen den Sensoranschlüssen entweder wieder ansteigt, falls diese bereits entsprechend abgefallen war, oder erst gar nicht auf den für den trockenen Zustand erwarteten Wert abfällt oder langsamer abfällt als für den trockenen Zustand erwartet. Dementsprechend kann die Auswerteeinheit durch Auswertung des Sensorsignals, insbesondere durch Auswertung des zeitlichen Verlaufs des Sensorsignals, durch Vergleich mit einem vorbestimmten Sollverhalten im trockenen Zustand des elektronischen Schaltkreises feststellen, ob sich die Feuchtigkeit zwischen der ersten Referenzstruktur und der Detektionsstruktur befindet.

Hierzu ist mit Vorteil keine dedizierte Spannungsversorgung der Detektionsstruktur notwendig. Ferner ist es per se nicht notwendig, den Eigenwiderstand der Detektionsstruktur genau zu kennen. Ebenfalls ist es nicht notwendig, einen Stromfluss durch die Detektionsstruktur zu erzeugen und die Veränderung dieses Stromflusses zu messen, um Feuchtigkeit zu detektieren. Im Vergleich zum Einprägen einer dedizierten Spannung und einer entsprechenden Strommessung sind also weniger Komponenten erforderlich, nämlich insbesondere lediglich ein Spannungssensor anstelle eines Stromsensors und einer Spannungsquelle. Auch entsprechende zusätzliche elektrische Verbindungen fallen nicht an. Dies kann auch Vorteile hinsichtlich eines Bauraums beziehungsweise des Flächenbedarfs auf einem Schaltungsträger des elektronischen Schaltkreises haben.

Bei der Feuchtigkeit, welche die erste Referenzstruktur mit der Detektionsstruktur koppelt, kann es sich beispielsweise um von außen eindringendes Wasser handeln. Es kann sich aber auch um eine Flüssigkeit handeln, die innerhalb des elektronischen Schaltkreises oder innerhalb eines Elektrogeräts oder eines Akkupacks, in oder mit dem der elektronische Schaltkreis verwendet werden kann, vorgesehen ist. Beispielsweise kann der elektronische Schaltkreis Teil eines Akkupacks mit mehreren Akkumulatorzellen sein. In diesem Fall kann die Feuchtigkeit beispielsweise einem aus einer beschädigten Akkumulatorzelle austretenden flüssigen Elektrolyt entsprechen.

Wird anhand der Auswertung des Sensorsignals durch die Auswerteeinheit festgestellt, dass die Feuchtigkeit vorliegt, so kann die Auswerteeinheit beispielsweise eine entsprechende Maßnahme, insbesondere eine risikoreduzierende Maßnahme, einleiten, beispielsweise den elektronischen Schaltkreis deaktivieren, einen entsprechenden Stromfluss unterbrechen und/oder ein Warnsignal erzeugen und so weiter. Hierzu kann die Auswerteeinheit gegebenenfalls auch weitere Komponenten des elektronischen Schaltkreises oder gegebenenfalls des Elektrogeräts beziehungsweise des Akkupacks ansteuern.

Der elektronische Schaltkreis beziehungsweise die Feuchtigkeitsdetektionsvorrichtung kann beispielsweise einen Analog-Digital-Umsetzer, ADU, aufweisen, welcher den Spannungssensor enthält oder den Spannungssensor darstellt. Dementsprechend können die Sensoranschlüsse Eingängen des ADU entsprechen.

Gemäß zumindest einer Ausführungsform des elektronischen Schaltkreises ist die Detektionsstruktur in einem trockenen Zustand des elektronischen Schaltkreises von der ersten Referenzstruktur und von der zweiten Referenzstruktur elektrisch getrennt, wenn der zweite Sensoranschluss durch die Schaltvorrichtung von der zweiten Referenzstruktur getrennt ist.

Der trockene Zustand des elektronischen Schaltkreises entspricht dabei insbesondere einem Zustand, in dem weder die erste Referenzstruktur noch die zweite Referenzstruktur durch Feuchtigkeit mit der Detektionsstruktur gekoppelt ist. Der trockene Zustand des elektronischen Schaltkreises kann beispielsweise auch als Sollzustand aufgefasst werden.

Dadurch ist die elektrische Potentiallage der Detektionsstruktur im trockenen Zustand unabhängig von dem ersten Referenzpotential an dem ersten Referenzpotentialanschluss und dem zweiten Referenzpotential an dem zweiten Referenzpotentialanschluss. Durch die Feuchtigkeit wird diese Unabhängigkeit aufgehoben, was zur Detektierbarkeit der Feuchtigkeit wie beschrieben führt.

Gemäß zumindest einer Ausführungsform ist die Auswerteeinheit dazu eingerichtet, das Sensorsignal zu erfassen, während der zweite Sensoranschluss mit der zweiten Referenzstruktur verbunden ist, um die Feuchtigkeit zu detektieren.

Die Auswertung des Sensorsignals kann in verschiedenen Ausgestaltungsformen des elektronischen Schaltkreises unterschiedlich sein. Beispielsweise kann die Schaltvorrichtung die zweite Referenzstruktur mit dem zweiten Sensoranschluss im Wesentlichen dauerhaft elektrisch verbinden, sodass nach einer gewissen Abklingzeit die elektrische Spannung zwischen den Sensoranschlüssen gleich null ist. Die Auswerteeinheit kann dann das Sensorsignal dahingehend überwachen, ob ein Anstieg des Sensorsignals beziehungsweise der Spannung zwischen den Sensoranschlüssen über einen vorgegebenen Grenzwert erfolgt. Ist dies der Fall, so kann auf das Vorliegen der Feuchtigkeit geschlossen werden.

In anderen Ausführungsformen kann die Auswerteeinheit die elektrische Verbindung zwischen dem zweitem Sensoranschluss und der zweiten Referenzstruktur zyklisch herstellen und wieder aufheben, sodass im trockenen Zustand bei jeder erneuten Verbindung des zweiten Sensoranschlusses mit der zweiten Referenzstruktur ein Abfall der entsprechenden Spannung zu beobachten ist. Die Auswerteeinheit kann nun den Verlauf der Spannung mit einem Sollverlauf vergleichen, um beispielsweise festzustellen, ob die Spannung langsamer abfällt als im trockenen Zustand erwartet und/oder ob die Spannung nach einer vorgegebenen Zeit wenigstens auf einen entsprechenden Grenzwert vorgegebenen abgefallen ist, um die Feuchtigkeit zu detektieren.

Gemäß zumindest einer Ausführungsform ist die Auswerteeinheit dazu eingerichtet, den zeitlichen Verlauf des Sensorsignals zu erfassen, während der zweite Sensoranschluss mit der zweiten Referenzstruktur verbunden ist, insbesondere mittels der Schaltvorrichtung, und die Feuchtigkeit abhängig von dem zeitlichen Verlauf zu detektieren.

Gemäß zumindest einer Ausführungsform ist die Schaltvorrichtung dazu eingerichtet, die zweite Referenzstruktur zu einem ersten Startzeitpunkt mit dem zweiten Sensoranschluss zu verbinden, wobei die zweite Referenzstruktur unmittelbar vor dem ersten Startzeitpunkt insbesondere nicht mit dem zweiten Sensoranschluss verbunden ist.

Gemäß zumindest einer Ausführungsform ist die Auswerteeinheit dazu eingerichtet, das Sensorsignal zu einem ersten Messzeitpunkt mit einem vorgegebenen Grenzwert zu vergleichen, wobei zwischen dem ersten Startzeitpunkt und dem ersten Messzeitpunkt ein vorgegebenes erstes Zeitintervall liegt. Die Auswerteeinheit ist dazu eingerichtet, die Feuchtigkeit abhängig von einem Ergebnis des Vergleichs zu detektieren.

Die Schaltvorrichtung weist dazu insbesondere ein Schaltelement auf, das zwischen der zweiten Referenzstruktur und dem zweiten Sensoranschluss angeordnet ist und das geöffnet werden kann, um die zweite Referenzstruktur von dem zweiten Sensoranschluss zu trennen, und das geschlossen werden kann, um die zweite Referenzstruktur mit dem zweiten Sensoranschluss zu verbinden. Die Schaltvorrichtung weist außerdem eine Steuereinheit auf, die das Schaltelement entsprechend steuern kann. Dabei kann die Auswerteeinheit die Steuereinheit beinhalten oder umgekehrt oder die beiden Einheiten können unabhängig voneinander ausgestaltet sein.

Stellt die Auswerteeinheit anhand der Auswertung des Sensorsignals, insbesondere anhand des Vergleichs mit dem Grenzwert, fest, dass die Spannung zwischen erstem und zweitem Sensoranschluss zu dem ersten Messzeitpunkt nicht wenigstens bis auf den Grenzwert abgefallen ist, so kann auf das Vorliegen der Feuchtigkeit geschlossen werden. Alternativ kann die Auswerteeinheit auch feststellen, ob die Spannung zunächst unter den Grenzwert fällt und diesen zu dem ersten Messzeitpunkt bereits wieder überschritten hat. Auch dies kann das Vorliegen der Feuchtigkeit anzeigen.

Gemäß zumindest einer Ausführungsform ist die Auswerteeinheit dazu eingerichtet, den zeitlichen Verlauf des Sensorsignals nach dem ersten Startzeitpunkt mit einem vorgegebenen Sollverlauf zu vergleichen und die Feuchtigkeit abhängig von einem Ergebnis dieses Vergleichs zu detektieren.

Gemäß zumindest einer Ausführungsform enthält die Feuchtigkeitsdetektionsvorrichtung eine elektrisch leitfähige weitere Detektionsstruktur, die in einer Umgebung der zweiten Referenzstruktur des elektronischen Schaltkreises angeordnet ist. Die Feuchtigkeitsdetektionsvorrichtung weist einen weiteren Spannungssensor auf, der einen weiteren ersten Sensoranschluss aufweist, der mit der weiteren Detektionsstruktur verbunden ist. Ein zweiter weiterer Sensoranschluss des weiteren Spannungssensors ist mit der ersten Referenzstruktur verbindbar. Der weitere Spannungssensor ist dazu eingerichtet, ein weiteres Sensorsignal abhängig von einer elektrischen Spannung zwischen dem ersten weiteren Sensoranschluss und dem zweiten weiteren Sensoranschluss zu erzeugen. Die Schaltvorrichtung ist dazu eingerichtet, den zweiten weiteren Sensoranschluss wahlweise von der ersten Referenzstruktur zu trennen und mit der ersten Referenzstruktur zu verbinden. Die Auswerteeinheit ist dazu eingerichtet, abhängig von dem weiteren Sensorsignal, das erzeugt wird, während der zweite weitere Sensoranschluss mit der ersten Referenzstruktur verbunden ist, Feuchtigkeit zu detektieren, welche die zweite Referenzstruktur mit der weiteren Detektionsstruktur elektrisch koppelt.

Die Auswerteeinheit kann dabei also das Sensorsignal und das zweite Sensorsignal auswerten. Optional kann die Auswerteeinheit dazu zwei voneinander unabhängige Auswerteuntereinheiten aufweisen, die gegebenenfalls auch räumlich voneinander getrennt sein können. Eine erste der Auswerteuntereinheiten kann dann das Sensorsignal erhalten und eine zweite der Auswerteuntereinheiten das weitere Steuersignal.

Die Schaltvorrichtung kann beispielsweise ein weiteres Schaltelement aufweisen, das zwischen der ersten Referenzstruktur und dem zweiten weiteren Sensoranschluss angeordnet ist, um die Verbindung zwischen erster Referenzstruktur und zweitem weiteren Sensoranschluss herzustellen beziehungsweise zu trennen.

Die Ausführungen bezüglich der Detektionsstruktur und dem Spannungssensor können analog auf Ausführungsformen mit der weiteren Detektionsstruktur und dem weiteren Spannungssensor übertragen werden, wobei die Rollen der ersten Referenzstruktur und der zweiten Referenzstruktur diesbezüglich vertauscht sind.

Gemäß zumindest einer Ausführungsform, insbesondere einer Ausführungsform, in der die Feuchtigkeitsdetektionsvorrichtung die weitere Detektionsstruktur und den weiteren Spannungssensor nicht aufweist, ist die Schaltvorrichtung dazu eingerichtet, den zweiten Sensoranschluss wahlweise von der ersten Referenzstruktur zu trennen und mit dieser zu verbinden, beispielsweise mittels eines entsprechend angeordneten weiteren Schaltelements der Schaltvorrichtung.

Die Schaltvorrichtung ist insbesondere dazu eingerichtet, den zweiten Sensoranschluss entweder mit der ersten Referenzstruktur oder mit der zweiten Referenzstruktur zu verbinden.

Dadurch können die obigen Ausführungen zur Detektion der Feuchtigkeit, welche die erste Referenzstruktur mit der Detektionsstruktur elektrisch koppelt, auf die Detektion von Feuchtigkeit übertragen werden, welche die zweite Referenzstruktur mit der Detektionsstruktur elektrisch koppelt. Daher kann mit Vorteil eine einzige Detektionsstruktur zur Detektion beider Situationen eingesetzt werden.

Gemäß zumindest einer Ausführungsform ist die Schaltvorrichtung dazu eingerichtet, während eines ersten Messzyklus den zweiten Sensoranschluss von der ersten Referenzstruktur zu trennen und den zweiten Sensoranschluss mit der zweiten Referenzstruktur zu verbinden.

Gemäß zumindest einer Ausführungsform ist die Schaltvorrichtung dazu eingerichtet, während eines zweiten Messzyklus, der auf den ersten Messzyklus folgt, beispielsweise unmittelbar folgt, den zweiten Sensoranschluss von der zweiten Referenzstruktur zu trennen und den zweiten Sensoranschluss mit der ersten Referenzstruktur zu verbinden.

Mit anderen Worten ist der zweite Sensoranschluss während des ersten Messzyklus mit der zweiten Referenzstruktur verbunden und von der ersten Referenzstruktur getrennt und/oder der zweite Sensoranschluss ist während des zweiten Messzyklus von der zweiten Referenzstruktur getrennt und mit der ersten Referenzstruktur verbunden.

Dementsprechend kann die Auswerteeinheit durch Auswertung des Sensorsignals während des ersten Messzyklus die Feuchtigkeit detektieren, die die erste Referenzstruktur mit der Detektionsstruktur koppelt und während des zweiten Messzyklus die Feuchtigkeit, welche die zweite Referenzstruktur mit der Detektionsstruktur koppelt. Weitere analoge erste und zweite Messzyklen können einander abwechselnd folgen, sodass abwechselnd beide Situationen detektiert werden können.

Der erste Messzyklus dauert beispielsweise von dem ersten Startzeitpunkt bis zu einem ersten Endzeitpunkt an, wobei der erste Messzeitpunkt zwischen dem ersten Startzeitpunkt und dem ersten Endzeitpunkt ist. Dementsprechend kann der zweite Messzyklus von einem zweiten Startzeitpunkt bis zu einem zweiten Endzeitpunkt andauern, wobei ein zweiter Messzeitpunkt zwischen dem zweiten Startzeitpunkt und dem zweiten Endzeitpunkt liegt, wobei insbesondere zwischen dem zweiten Startzeitpunkt und dem zweiten Messzeitpunkt ein vorgegebenes zweites Zeitintervall liegt.

Die Auswerteeinheit kann beispielsweise das Sensorsignal zu dem zweiten Messzeitpunkt mit einem vorgegebenen weiteren Grenzwert vergleichen und abhängig von einem Ergebnis dieses Vergleichs die Feuchtigkeit detektieren, welche die zweite Referenzstruktur mit der Detektionsstruktur koppelt.

Auch die weiteren Möglichkeiten zur Detektion der Feuchtigkeit, welche die erste Referenzstruktur mit der Detektionsstruktur koppelt, können entsprechend zur Detektion der Feuchtigkeit, welche die zweite Referenzstruktur mit der Detektionsstruktur koppelt, übertragen werden.

Gemäß zumindest einer Ausführungsform ist die Auswerteeinheit dazu eingerichtet, das Sensorsignal zu erfassen, während der zweite Sensoranschluss mit der ersten Referenzstruktur verbunden ist, insbesondere während des zweiten Messzyklus, um die Feuchtigkeit zu detektieren, welche die zweite Referenzstruktur mit der Detektionsstruktur elektrisch koppelt. Insbesondere kann die Auswerteeinheit dazu eingerichtet sein, einen zeitlichen Verlauf des Sensorsignals zu erfassen, während der zweite Sensoranschluss mit der ersten Referenzstruktur verbunden ist, und die entsprechende Feuchtigkeit abhängig von dem zeitlichen Verlauf detektieren.

Gemäß zumindest einer Ausführungsform ist die Auswerteeinheit dazu eingerichtet, eine risikoreduzierende Maßnahme einzuleiten, wenn die Feuchtigkeit detektiert wurde, die die erste Referenzstruktur mit der Detektionsstruktur elektrisch koppelt.

Gemäß zumindest einer Ausführungsform ist die Auswerteeinheit dazu eingerichtet, die risikoreduzierende Maßnahme einzuleiten, wenn die Feuchtigkeit detektiert wurde, welche die zweite Referenzstruktur mit der Detektionsstruktur oder der weiteren Detektionsstruktur elektrisch koppelt.

Das Einleiten der risikoreduzierenden Maßnahme kann beispielsweise das Erzeugen oder Veranlassen eines Warnsignals beinhalten und/oder das Erzeugen oder Veranlassen eines Steuersignals für ein weiteres Schaltelement, um einen Stromfluss durch den elektronischen Schaltkreis zu unterbrechen oder dergleichen. Das Einleiten der risikoreduzierenden Maßnahme kann auch beinhalten, den elektronischen Schaltkreis und/oder ein Elektrogerät und/oder ein Akkupack zu deaktivieren, das mit dem elektronischen Schaltkreis verbunden ist oder den elektronischen Schaltkreis beinhaltet.

Gemäß zumindest einer Ausführungsform ist die Auswerteeinheit dazu eingerichtet, eine Unterbrechung einer elektrischen Verbindung des ersten Referenzpotentialanschlusses mit der ersten Referenzstruktur und/oder einer elektrischen Verbindung des zweiten Referenzpotentialanschlusses mit der zweiten Referenzstruktur einzuleiten, um die risikoreduzierende Maßnahme einzuleiten.

Dazu können der elektronische Schaltkreis, die Feuchtigkeitsdetektionseinrichtung oder die Schaltvorrichtung entsprechend durch die Auswerteeinheit ansteuerbare Schaltelemente aufweisen.

Gemäß einem weiteren Aspekt der Erfindung wird ein Akkupack zur Versorgung eines Elektrogeräts mit elektrischer Energie angegeben. Das Akkupack weist wenigstens eine Akkumulatorzelle auf, insbesondere eine Lithium-Ionen-Akkumulatorzelle. Die wenigstens eine Akkumulatorzelle weist eine erste Elektrode und eine zweite Elektrode auf. Das Akkupack weist einen erfindungsgemäßen elektronischen Schaltkreis auf. Der erste Referenzpotentialanschluss des elektronischen Schaltkreises ist dabei mit der ersten Elektrode direkt oder indirekt verbunden und der zweite Referenzpotentialanschluss ist mit der zweiten Elektrode des Akkupacks direkt oder indirekt verbunden.

Gemäß zumindest einer Ausführungsform des Akkupacks enthält der elektronische Schaltkreis ein Batteriemanagementsystem für das Akkupack.

Gemäß zumindest einer Ausführungsform enthält der elektronische Schaltkreis wenigstens ein Schaltelement zum Unterbrechen eines Entladestroms von der wenigstens einen Akkumulatorzelle zu dem Elektrogerät und/oder wenigstens ein Schaltelement zum Unterbrechen eines Ladestroms von einem Ladegerät zu der wenigstens einen Akkumulatorzelle.

Die risikoreduzierende Maßnahme kann dann beispielsweise das Unterbrechen des Entladestroms und/oder des Ladestroms beinhalten.

Gemäß einem weiteren Aspekt der Erfindung wird ein Elektrogerät mit einem erfindungsgemäßen elektronischen Schaltkreis und/oder mit einem erfindungsgemäßen Akkupack angegeben.

Das Elektrogerät kann beispielsweise als Elektrowerkzeug oder elektrisches Haushaltsgerät ausgestaltet sein. Das Elektrogerät kann auch als elektrisch antreibbares Fahrzeug, insbesondere Kleinfahrzeug, ausgestaltet sein, beispielsweise als elektrisch antreibbarer Fahrrad oder elektrisch antreibbaren Roller oder dergleichen.

Gemäß einem weiteren Aspekt der Erfindung wird ein Verfahren zur Detektion von Feuchtigkeit in einem elektronischen Schaltkreis angegeben. Dabei wird, insbesondere mittels einer Schaltvorrichtung des elektronischen Schaltkreises, ein zweiter Sensoranschluss eines Spannungssensors, insbesondere des elektronischen Schaltkreises, mit einer elektrisch leitfähigen zweiten Referenzstruktur des elektronischen Schaltkreises verbunden, wobei die zweite Referenzstruktur mit einem zweiten Referenzpotentialanschluss des elektronischen Schaltkreises verbunden ist. Mittels des Spannungssensors wird ein Sensorsignal abhängig von einer Spannung zwischen einem ersten Sensoranschluss des Spannungssensors und dem zweiten Sensoranschluss erzeugt. Der erste Sensoranschluss ist dabei mit einer elektrisch leitfähigen Detektionsstruktur des elektronischen Schaltkreises verbunden und die Detektionsstruktur ist in einer Umgebung einer elektrisch leitfähigen ersten Referenzstruktur des elektronischen Schaltkreises angeordnet. Abhängig von dem Sensorsignal wird, insbesondere mittels einer Auswerteeinheit des elektronischen Schaltkreises, Feuchtigkeit detektiert, welche die erste Referenzstruktur mit der Detektionsstruktur elektrisch koppelt.

Weitere Ausführungsformen des erfindungsgemäßen Verfahrens folgen direkt aus den verschiedenen Ausgestaltungsformen des erfindungsgemäßen elektronischen Schaltkreises, des erfindungsgemäßen Akkupacks und des erfindungsgemäßen Elektrogeräts und jeweils umgekehrt. Insbesondere kann ein erfindungsgemäßer elektronischer Schaltkreis dazu eingerichtet sein, ein erfindungsgemäßes Verfahren durchzuführen oder er führt ein solches Verfahren durch.

Die Erfindung wird im Folgenden anhand konkreter Ausführungsbeispiele und zugehöriger schematischer Zeichnungen näher erläutert. In den Figuren können gleiche oder funktionsgleiche Elemente mit denselben Bezugszeichen versehen sein. Die Beschreibung gleicher oder funktionsgleicher Elemente wird gegebenenfalls nicht notwendigerweise bezüglich verschiedener Figuren wiederholt.

In den Figuren zeigen:
- Fig. 1: eine schematische Darstellung einer beispielhaften Ausführungsform eines erfindungsgemäßen elektronischen Schaltkreises;
- Fig. 2: eine schematische Darstellung eines Spannungsverlaufs;
- Fig. 3: eine schematische Darstellung einer weiteren beispielhaften Ausführungsform eines erfindungsgemäßen elektronischen Schaltkreises;
- Fig. 4: eine schematische Darstellung von weiteren Spannungsverläufen;
- Fig. 5: eine schematische Darstellung einer weiteren beispielhaften Ausführungsform eines erfindungsgemäßen elektronischen Schaltkreises;
- Fig. 6a: eine schematische Darstellung einer beispielhaften Ausführungsform eines erfindungsgemäßen Akkupacks;
- Fig. 6b: eine schematische Darstellung einer Kontaktanordnung des Akkupacks aus Fig. 6a;
- Fig. 7: eine schematische Schnittdarstellung durch eine weitere beispielhafte Ausführungsform eines erfindungsgemäßen Akkupacks; und
- Fig. 8: eine schematische Schnittdarstellung durch eine Akkumulatorzelle einer weiteren beispielhaften Ausführungsform eines erfindungsgemäßen Ackupacks.

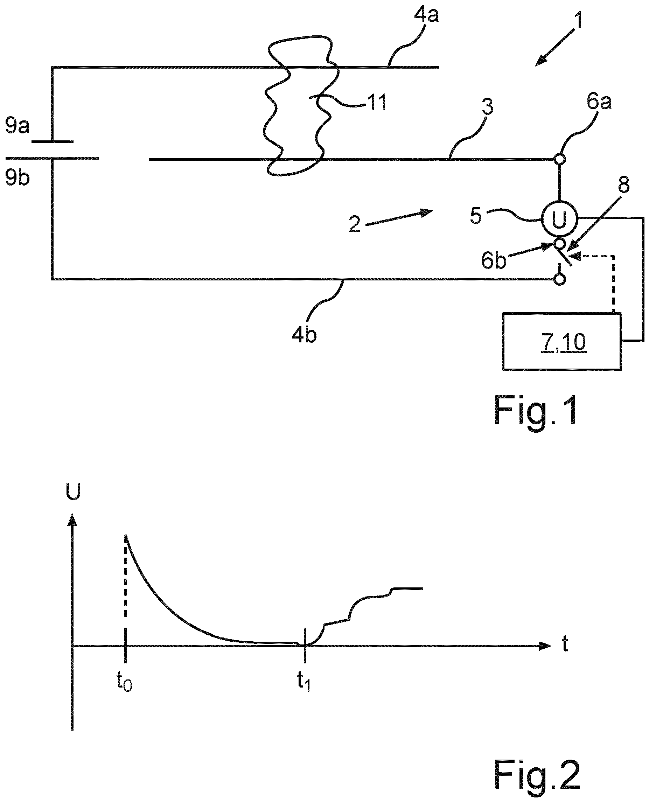

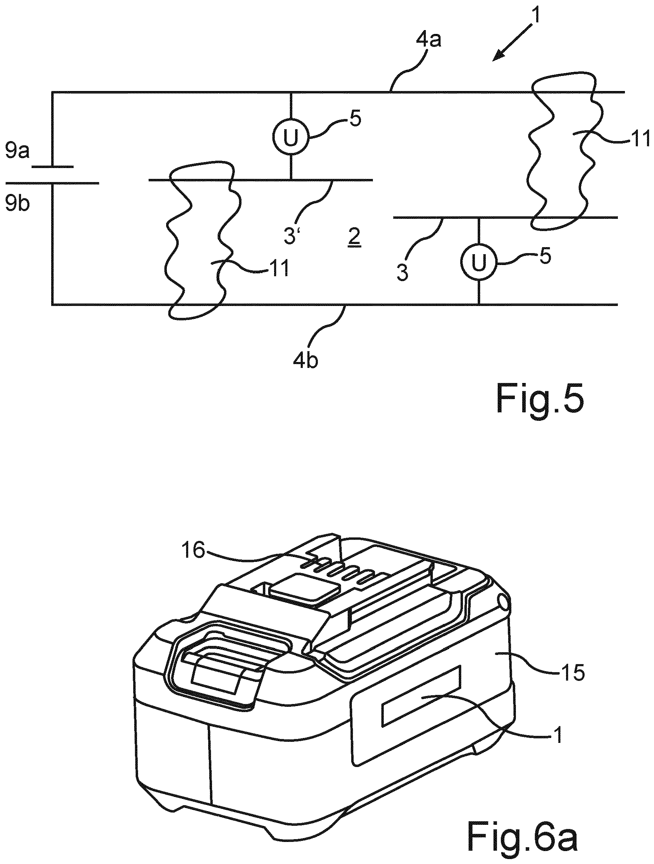

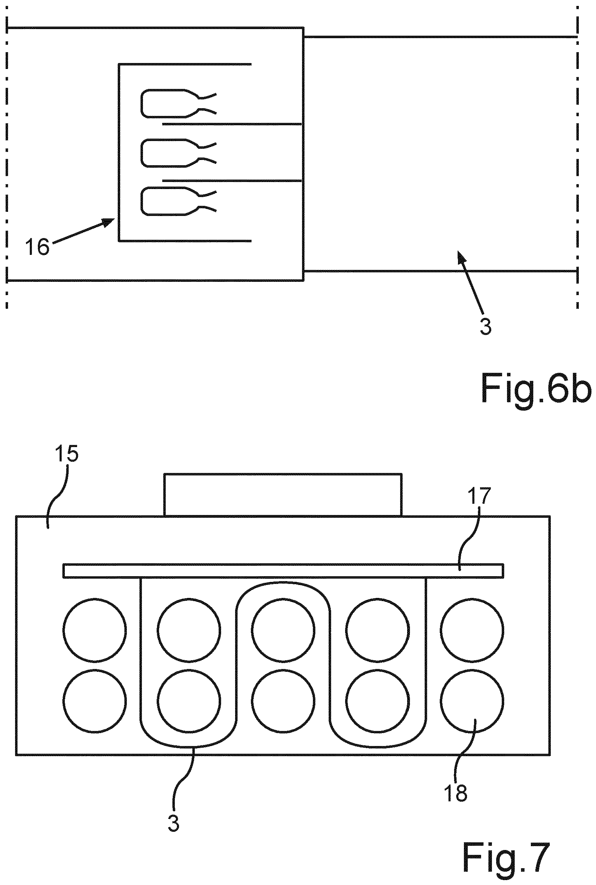

In Fig. 1 ist ein erfindungsgemäßer elektronischer Schaltkreis 1 schematisch dargestellt. Der Schaltkreis 1 weist einen ersten Referenzpotentialanschluss 9a und einen zweiten Referenzpotentialanschluss 9b auf, die beispielsweise mit entsprechenden Elektroden einer Spannungsquelle verbunden sein können. Beispielsweise kann der elektronische Schaltkreis 1 Teil eines Akkupacks 15 (siehe Fig. 6a) mit mehreren Ackumulatorzellen 18 (siehe Fig. 7) sein. Die Akkumulatorzellen 18 können beispielsweise in Reihe und/oder parallel verschaltet sein und eine gemeinsame erste Elektrode sowie eine gemeinsame zweite Elektrode zum Ausgeben einer Ausgangsspannung aufweisen. In diesem Fall kann die erste Elektrode mit dem ersten Referenzpotentialanschluss 9a verbunden sein und die zweite Elektrode mit dem zweiten Referenzpotentialanschluss 9b. Der elektronische Schaltkreis 1 lässt sich jedoch auch in anderen Konstellationen verwenden, wobei die Referenzpotentialanschlüsse 9a, 9b auf unterschiedlichen elektrischen Potentialen liegen.

Der Schaltkreis 1 weist eine elektrisch leitfähige erste Referenzstruktur 4a auf, die mit dem ersten Referenzpotentialanschluss 9a verbunden ist, sowie eine elektrisch leitfähige zweite Referenzstruktur 4b, die mit dem zweiten Referenzpotentialanschluss 9b verbunden ist. Die Referenzstrukturen 4a, 4b können beispielsweise Leiterbahnen oder Verdrahtungen des Schaltkreises 1 entsprechen. Der Schaltkreis 1 kann dabei eine Vielzahl weiterer elektronischer Komponenten aufweisen, die der Übersicht halber in Fig. 1 nicht dargestellt sind. Der elektronische Schaltkreis 1 weist außerdem eine Feuchtigkeitsdetektionsvorrichtung 2 auf. Die Funktion der Feuchtigkeitsdetektionsvorrichtung 2 ist dabei unabhängig von der konkreten Ausgestaltung der übrigen Komponenten des Schaltkreises 1, sodass im Folgenden lediglich auf die Referenzstrukturen 4a, 4b sowie die Referenzpotentialanschlüsse 9a, 9b Bezug genommen wird.

Die Feuchtigkeitsdetektionsvorrichtung 2 enthält eine elektrisch leitfähige Detektionsstruktur 3, die beispielsweise ebenfalls als Draht oder Leiterbahn ausgestaltet sein kann und die in einer Umgebung der ersten Referenzstruktur 4a angeordnet ist. Die Feuchtigkeitsdetektionsvorrichtung 2 weist außerdem einen Spannungssensor 5 auf mit einem ersten Sensoranschluss 6a, der mit der Detektionsstruktur 3 verbunden ist, und mit einem zweiten Sensoranschluss 6b, der über ein Schaltelement 8 mit der zweiten Referenzstruktur 4b verbunden werden kann beziehungsweise von dieser getrennt werden kann. Hierzu weist die Feuchtigkeitsdetektionsvorrichtung 2 eine Steuereinheit 10 auf, die das Schaltelement 8 entsprechend ansteuern kann, um die Verbindung herzustellen beziehungsweise aufzuheben. Das Schaltelement 8 kann einen Transistor, beispielsweise einen Feldeffekttransistor, beinhalten.

Die Feuchtigkeitsdetektionseinrichtung 2 weist außerdem eine Auswerteeinheit 7 auf, die mit dem Spannungssensor 5 verbunden ist beziehungsweise in manchen Ausführungsformen den Spannungssensor 5 beinhalten kann. Die Auswerteeinheit 7 und die Steuereinheit 10 können in verschiedenen Ausführungsformen auch als gemeinsame Steuer- und Auswerteeinheit ausgebildet sein.

Der Spannungssensor 5 kann ein Sensorsignal erzeugen, das die Spannung zwischen den beiden Sensoranschlüssen 6a, 6b wiedergibt. Ist das Schaltelement 8 also geschlossen, sodass die zweite Referenzstruktur 4b mit dem zweiten Sensoranschluss 6b verbunden ist, so gibt das Sensorsignal also die Spannung U zwischen der Detektionsstruktur 3 und der zweiten Referenzstruktur 4b wieder. Ein entsprechender Verlauf der Spannung U ist schematisch in Fig. 2 als Funktion der Zeit t dargestellt.

Im Beispiel der Fig. 2 ist das Schaltelement 8 beispielsweise zunächst geöffnet und wird mittels der Steuereinheit 10 zu einem Startzeitpunk t₀ geschlossen. In einem trockenen Zustand des elektronischen Schaltkreises 1 ist die Detektionsstruktur 3 elektrisch von der ersten Referenzstruktur 4a und von der zweiten Referenzstruktur 4b getrennt, sofern das Schaltelement 8 geöffnet ist. Daher ist das elektrische Potential der Detektionsstruktur 3 im Allgemeinen unbestimmt, also schwebend. Dementsprechend stellt sich also zum Zeitpunkt t₀ ein Spannungsabfall zwischen Detektionsstruktur 3 und zweiter Referenzstruktur 4b ein. Durch den endlichen Innenwiderstand des Spannungssensors 5 fällt diese Spannung jedoch mit der Zeit ab und erreicht im trockenen Zustand des elektronischen Schaltkreises 1 zu einem späteren Zeitpunkt t₁ beispielsweise näherungsweise null.

Befindet sich jedoch Feuchtigkeit 11 in dem elektronischen Schaltkreis 1, welche, wie in Fig. 1 angedeutet, die erste Referenzstruktur 4a mit der Detektionsstruktur 3 elektrisch verbindet, so kann wenigstens ein teilweiser Ladungsausgleich zwischen der Detektionsstruktur 3 und der ersten Referenzstruktur 4a stattfinden. Da die Referenzstrukturen 4a, 4b auf unterschiedlichen elektrischen Potentialen liegen, führt dies zu einer Spannung größer null zwischen den Sensoranschlüssen 6a, 6b. Dementsprechend kann die Spannung U nach dem Zeitpunkt t₁ wieder ansteigen, wie in Fig. 2 angedeutet. Wird die Verbindung des zweiten Sensoranschlusses 6b mit der zweiten Referenzstruktur 4b durch Schließen des Schaltelements 8 hergestellt, wenn bereits die Feuchtigkeit 11 vorhanden ist, so fällt die Spannung U gegebenenfalls nicht wie in Fig. 2 angedeutet auf null ab, sondern bleibt bei einem höheren Wert. Ein entsprechender Verlauf oder Wert der Spannung U kann mittels der Auswerteeinheit 7 mit einem erwarteten Sollverlauf oder Sollwert der Spannung verglichen werden, um die Feuchtigkeit 11 zu detektieren.

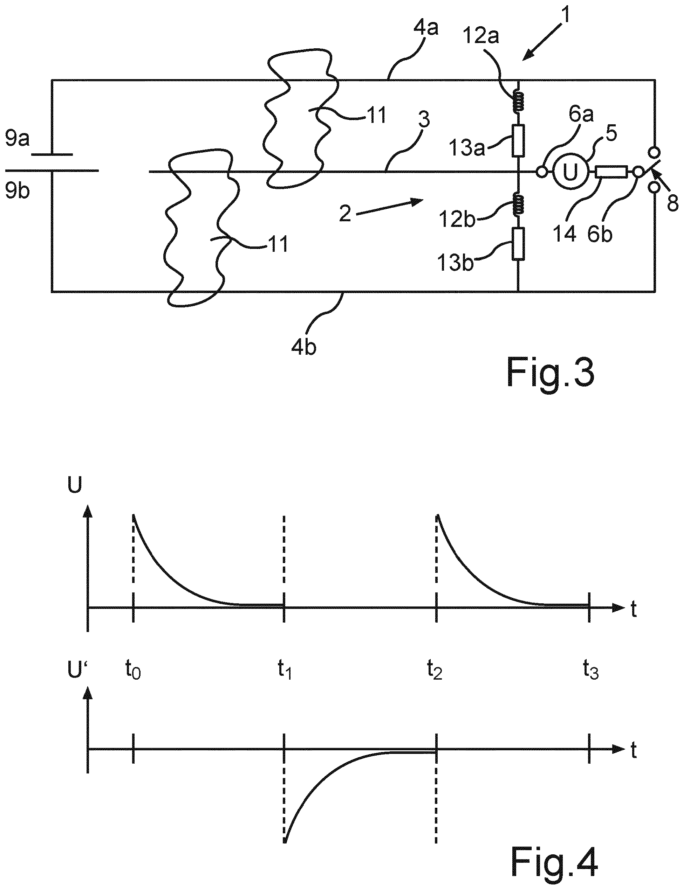

In Fig. 3 ist schematisch eine weitere beispielhafte Ausführungsform des erfindungsgemäßen elektronischen Schaltkreises 1 dargestellt, die auf der Ausführungsform der Fig. 1 basiert.

In der Ausführungsform der Fig. 3 sind die Auswerteeinheit 7 und die Steuereinheit 10 aus Gründen der Übersichtlichkeit nicht dargestellt. Das Schaltelement 8 kann beispielsweise als Wechselschalter ausgestaltet sein oder wirken. Die Steuereinheit 10 kann das Schaltelement 8 dann derart ansteuern, dass der zweite Sensoranschluss 6b mit der ersten Referenzstruktur 4a verbunden ist und von der zweiten Referenzstruktur getrennt ist oder umgekehrt. Alternativ kann die Feuchtigkeitsdetektionsvorrichtung 2 ein Schaltelement 8 wie bezüglich Fig. 1 erläutert aufweisen sowie ein weiteres Schaltelement (nicht dargestellt), das ebenfalls durch die Steuereinheit 10 angesteuert werden kann und zwischen der ersten Referenzstruktur 4a und der Detektionsstruktur 3 angeordnet ist. Dementsprechend kann die Steuereinheit 10 das Schaltelement 8 und das weitere Schaltelement derart ansteuern, sodass das Schaltelement 8 geschlossen ist und das weitere Schaltelement geöffnet ist oder umgekehrt.

Also kann die Steuereinheit 10 die Detektionsstruktur 3 wahlweise mit der ersten Referenzstruktur 4a und der zweiten Referenzstruktur 4b verbinden. Ist die Detektionsstruktur 3 mit der zweiten Referenzstruktur 4b verbunden und von der ersten Referenzstruktur 4a getrennt, so kann die Auswerteeinheit 7 die Feuchtigkeit 11 zwischen der ersten Referenzstruktur 4a und der Detektionsstruktur 3 wie bezüglich Fig. 1 beschrieben detektieren. Ist die Detektionsstruktur 3 dagegen mit der ersten Referenzstruktur 4a verbunden und von der zweiten Referenzstruktur 4b getrennt, so kann die Auswerteeinheit 7 eine Feuchtigkeit 11 detektieren, welche die zweite Referenzstruktur 4b mit der Detektionsstruktur 3 elektrisch verbindet. Hierbei gelten die Ausführungen bezüglich Fig. 1 und Fig. 2 analog.

In verschiedenen Ausgestaltungsformen kann die Steuereinheit 10 das Schaltelement 8 und das weitere Schaltelement derart zyklisch ansteuern, dass während aufeinanderfolgender Messzyklen abwechselnd die erste Referenzstruktur 4a oder die zweite Referenzstruktur 4b mit der Detektionsstruktur 3 verbunden ist, um abwechselnd die entsprechende Feuchtigkeitsdetektion durchzuführen. Ein entsprechender Spannungsverlauf zwischen den beiden Sensoranschlüssen 6a, 6b ist schematisch in Fig. 4 dargestellt. Dabei entspricht der Spannungsverlauf U als Funktion der Zeit t dem Verlauf der Spannung zwischen zweiter Referenzstruktur 4b und Detektionsstruktur 3 und der Spannungsverlauf U' als Funktion der Zeit t entspricht dem Spannungsverlauf zwischen der ersten Referenzstruktur 4a und der Detektionsstruktur 3. Wie bezüglich Fig. 2 ausgeführt, wird die zweite Referenzstruktur 4b zum Zeitpunkt t₀ mit der Detektionsstruktur 3 verbunden, sodass die Spannung U von einem endlichen Wert bis um Zeitpunkt t₁ auf einen Wert nahe null abfällt. Zum Zeitpunkt t₁ wird dann beispielsweise die zweite Referenzstruktur 4b von der Detektionsstruktur 3 getrennt und die Detektionsstruktur 3 mit der ersten Referenzstruktur 4a verbunden. Dementsprechend nimmt die Spannung U' einen endlichen Wert an, der im Verlauf der Zeit bis zu einem weiteren Zeitpunkt t₂ beispielsweise auf einen Wert nahe null abfällt. Zum Zeitpunkt t₂ wird wiederum die Detektionsstruktur 3 von der ersten Referenzstruktur 4a getrennt und mit der zweiten Referenzstruktur 4b verbunden, sodass sich der Spannungsverlauf der Spannung U zwischen t₂ und einer darauffolgenden Zeit t₃ wie beschrieben wiederholt. Es sei darauf hingewiesen, dass dieser skizzierte Verlauf der Spannungen U, U' dem trockenen Zustand des Schaltkreises 1 entspricht. Entsprechende Abweichungen, wie bezüglich Fig. 2 beschrieben, lassen die Auswerteeinheit 7 dementsprechend auf die Feuchtigkeit 11 zwischen der Detektionsstruktur 3 und einer der Referenzstrukturen 4a, 4b schließen.

In Fig. 3 ist ein optionaler Widerstand 14 dargestellt, der in Reihe mit dem Innenwiderstand des Spannungssensors 5 geschaltet ist. Dadurch kann der elektrische Widerstand zwischen den Sensoranschlüssen 6a, 6b weiter erhöht werden, um so den beschriebenen Abfall der Spannung zu verzögern. Auf diese Weise kann der Spannungsverlauf entsprechend der konkreten Bedürfnisse angepasst werden. Ein solcher Widerstand 14 kann auch in Ausführungsformen gemäß Fig. 1 vorgesehen sein.

Ferner sind in Fig. 3 ein optionales induktives Element 12a und ein optionaler Widerstand 13a in Reihe zwischen der ersten Referenzstruktur 4a und der Detektionsstruktur 3 geschaltet. Durch entsprechende Wahl der Induktivität des induktiven Elements 12a und des ohmschen Widerstands des Widerstands 13a kann die Kopplung dementsprechend eingestellt werden, um den zeitlichen Verlauf der Spannung während der Messintervalle zur Detektion der Feuchtigkeit 11 einzustellen. Auch dies kann in Ausführungsformen nach Fig. 1 optional vorgesehen sein. Des Weiteren kann, wie in Fig. 3 dargestellt, ein weiteres induktives Element 12b in Reihe mit einem weiteren Widerstand 13b zwischen der Detektionsstruktur 3 und der zweiten Referenzstruktur 4b geschaltet sein. Diese haben eine analoge Funktion wie bezüglich des induktiven Elements 12a und des Widerstands 13a ausgeführt.

In Fig. 5 ist eine weitere beispielhafte Ausführungsform des erfindungsgemäßen elektronischen Schaltkreises 1 dargestellt, die auf der Ausführungsform der Fig. 1 beruht.

Der Übersichtlichkeit halber sind die Sensoranschlüsse 6a, 6b sowie die Steuereinheit 10 und die Auswerteeinheit 7 ebenso wie das Schaltelement 8 nicht dargestellt.

In der Ausführungsform der Fig. 5 weist die Feuchtigkeitsdetektionseinrichtung 2 eine weitere Detektionsstruktur 3' auf, die in einer Umgebung der zweiten Referenzstruktur 4b angeordnet ist. Die Feuchtigkeitsdetektionseinrichtung 2 enthält außerdem einen weiteren Spannungssensor 5', der einen weiteren ersten Sensoranschluss aufweist, der mit der weiteren Detektionsstruktur 3' verbunden ist, sowie einen zweiten Sensoranschluss, der schaltbar mit der ersten Referenzstruktur 4a verbunden ist. Dazu weist die Feuchtigkeitsdetektionseinrichtung 2 ein weiteres Schaltelement (nicht dargestellt) auf, das von der Steuereinheit 10 angesteuert werden kann, um die erste Referenzstruktur 4a mit dem weiteren zweiten Sensoranschluss zu verbinden beziehungsweise von diesem zu trennen. Die Funktionsweise der Detektionsstruktur 3' beziehungsweise des Spannungssensors 5' ist analog zu der Funktionsweise der Detektionsstruktur 3 und des Spannungssensors 5, wie bezüglich Fig. 1 beschrieben.

Gemäß der Ausführungsform der Fig. 5 kann also die Feuchtigkeit 11, welche die Detektionsstruktur 3 mit der ersten Referenzstruktur 4a koppelt, durch Auswertung des Sensorsignals des Spannungssensors 5 wie beschrieben detektiert werden. Feuchtigkeit 11, die die weitere Detektionsstruktur 3' mit der zweiten Referenzstruktur 4b koppelt, kann in analoger Weise durch Auswertung eines weiteren Sensorsignals des weiteren Spannungssensors 5' von der Auswerteeinheit 7 detektiert werden.

In Fig. 6a ist schematisch eine beispielhafte Ausführungsform eines erfindungsgemäßen Akkupacks 15, das einen erfindungsgemäßen elektronischen Schaltkreis 1 aufweist, wie er beispielsweise hinsichtlich der Fig. 1 bis Fig. 5 erläutert wurde.

Das Akkupack 15 weist wenigstens eine Akkumulatorzelle 18 (siehe Fig. 7) auf, wobei eine erste Elektrode der Akkumulatorzellen 18 mit dem ersten Referenzpotentialanschluss 9a verbunden ist und eine zweite Elektrode der Akkumulatorzellen 18 mit dem zweiten Referenzpotentialanschluss 9b.

Das Akkupack 15 kann außerdem zwei oder mehr externe Kontakte 16 zur Verbindung des Akkupacks 15 mit einem Elektrogerät aufweisen. Ein erster der externen Kontakte 16 ist dabei mit dem ersten Referenzpotentialanschluss 9a verbunden und ein zweiter der externen Kontakte 16 mit dem zweiten Referenzpotentialanschluss 9b. Die externen Kontakte 16 stellen potentielle Stellen zum Eindringen von Feuchtigkeit in das Ackupack 15 und damit in den elektrischen Schaltkreis 1 dar.

In Fig. 6b ist eine mögliche Anordnung der Detektionsstruktur 3 des Schaltkreises 1 bezüglich der externen Kontakte 16 schematisch dargestellt. So kann beispielsweise ein Teil der Detektionsstruktur 3 zwischen benachbarten der externen Kontakte 16 angeordnet sein, um entsprechend Feuchtigkeit detektieren zu können.

In Fig. 7 ist eine Schnittdarstellung durch eine weitere beispielhafte Ausführungsform eines erfindungsgemäßen Akkupacks 15 dargestellt. Das Akkupack 15 kann hier beispielsweise eine Platine 17 enthalten, die etwa ein Batteriemanagementsystem für das Akkupack 15 trägt. Ferner kann die Platine 17 den elektronischen Schaltkreis 1 beziehungsweise die Feuchtigkeitsdetektionsvorrichtung 2 teilweise tragen. Die Detektionsstruktur 3 kann beispielsweise eine oder mehrere Drahtschlaufen aufweisen, die durch den Bereich des Akkupacks 15 geführt sind, in welchem die Akkumulatorzellen 18 angeordnet sind. Die Detektionsstruktur 3 kann beispielsweise mäanderförmig zwischen den einzelnen Akkumulatorzellen 18 verlaufen. Auf diese Weise kann Feuchtigkeit detektiert werden, die in den Bereich der Akkumulatorzellen 18 eindringen und daher von besonderer Sicherheitsrelevanz sind.

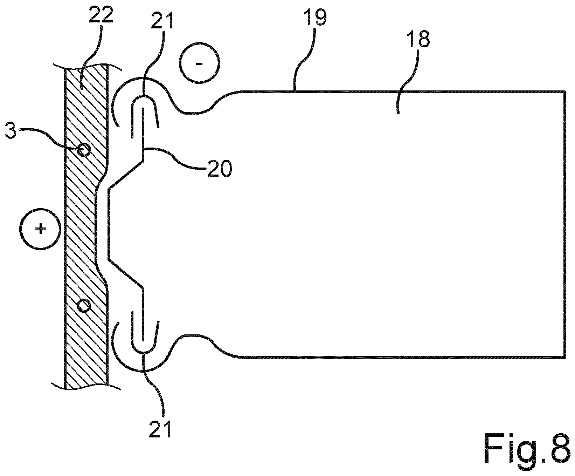

In Fig. 8 ist eine schematische Schnittdarstellung durch eine Akkumulatorzelle 18 eines erfindungsgemäßen Akkupacks 15 dargestellt. Die Akkumulatorzelle 18 weist ein Gehäuse 19 auf, welches eine negative Elektrode der Akkumulatorzelle 18 bildet und beispielsweise mit dem ersten Referenzpotentialanschluss 9a verbunden ist. Des Weiteren weist die Akkumulatorzelle 18 ein Stromunterbrechungselement 20 auf, das auch als CID (englisch: "Current Interruption Device") bezeichnet wird und das mittels eines Isolationselements 21 der Akkumulatorzelle 18 elektrisch von dem Gehäuse 19 isoliert ist. Das Stromunterbrechungselement 20 kann einer positiven Elektrode der Akkumulatorzelle 18 entsprechen und beispielsweise mit dem zweiten Referenzpotentialanschluss 9b verbunden sein.

Fig. 8 zeigt außerdem eine weitere beispielhafte Anordnung der Detektionsstruktur 3, die auch hier als Drahtschlaufenstruktur ausgebildet sein kann. Die Detektionsstruktur 3 ist beispielsweise derart geführt, dass sie in der Nähe des Stromunterbrechungselements 20 und des Gehäuses 19 verläuft, beispielsweise zwischen dem Gehäuse 19 und dem Stromunterbrechungselement 20. So kann Feuchtigkeit an besonders kritischen Stellen des Akkupacks 15 detektiert werden.

Beispielsweise kann die Detektionsstruktur 3 dazu in ein weiteres Isolationselement 22 eingebettet sein, das beispielsweise porös oder schwammartig ausgestaltet ist, sodass Feuchtigkeit durch das elektrisch Isolationselement 22 zu der Detektionsstruktur 3 dringen kann, die Detektionsstruktur 3 aber dennoch von dem Gehäuse 19 und dem Stromunterbrechungselement 20 elektrisch isoliert wird.

### BEZUGSZEICHENLISTE:

- 1: Schaltkreis
- 2: Feuchtigkeitsdetektionsvorrichtung
- 3, 3': Detektionsstrukturen
- 4a, 4b: Referenzstrukturen
- 5, 5': Spannungssensoren
- 6a, 6b: Sensoranschlüsse
- 7: Auswerteeinheit
- 8: Schaltelement
- 9a, 9b: Referenzpotentialanschlüsse
- 10: Steuereinheit
- 11: Feuchtigkeit
- 12a, 12b: induktive Elemente
- 13a, 13b, 14: Widerstände
- 15: Akkupack
- 16: externe Anschlüsse
- 17: Platine
- 18: Akkumulatorzellen
- 19: Gehäuse
- 20: Stromunterbrechungselement
- 21, 22: Isolationselemente

## Patentansprüche

1. Elektronischer Schaltkreis (1) mit einer Feuchtigkeitsdetektionsvorrichtung (2), die Feuchtigkeitsdetektionsvorrichtung (2) aufweisend
- eine elektrisch leitfähige Detektionsstruktur (3), die in einer Umgebung einer elektrisch leitfähigen ersten Referenzstruktur (4a) des elektronischen Schaltkreises (1) angeordnet ist, wobei die erste Referenzstruktur (4a) mit einem ersten Referenzpotentialanschluss (9a) des elektronischen Schaltkreises (1) verbunden ist;
- einen Spannungssensor (5) mit einem ersten Sensoranschluss (6a), der mit der Detektionsstruktur (3) verbunden ist, und mit einem zweiten Sensoranschluss (6b), der mit einer elektrisch leitfähigen zweiten Referenzstruktur (4b) des elektronischen Schaltkreises (1) verbindbar ist, die mit einem zweiten Referenzpotentialanschluss (9b) des Schaltkreises (1) verbunden ist, wobei der Spannungssensor (5) dazu eingerichtet ist, ein Sensorsignal abhängig von einer elektrischen Spannung zwischen dem ersten Sensoranschluss (6a) und dem zweiten Sensoranschluss (6b) zu erzeugen;
- eine Schaltvorrichtung (8, 10), die dazu eingerichtet ist, den zweiten Sensoranschluss (6b) wahlweise von der zweiten Referenzstruktur (4b) zu trennen und mit dieser zu verbinden, und
- eine Auswerteeinheit (7), die dazu eingerichtet ist, abhängig von dem Sensorsignal Feuchtigkeit (11) zu detektieren, welche die erste Referenzstruktur (4a) mit der Detektionsstruktur (3) elektrisch koppelt.

2. Elektronischer Schaltkreis (1) nach Anspruch 1, wobei die Auswerteeinheit (7) dazu eingerichtet ist, das Sensorsignal zu erfassen, während der zweite Sensoranschluss (6b) mit der zweiten Referenzstruktur (4b) verbunden ist, um die Feuchtigkeit (11) zu detektieren.

3. Elektronischer Schaltkreis (1) nach einem der vorhergehenden Ansprüche, wobei die Auswerteeinheit (7) dazu eingerichtet ist, einen zeitlichen Verlauf des Sensorsignals zu erfassen, während der zweite Sensoranschluss (6b) mit der zweiten Referenzstruktur (4b) verbunden ist, und die Feuchtigkeit (11) abhängig von dem zeitlichen Verlauf zu detektieren.

4. Elektronischer Schaltkreis (1) nach einem der vorhergehenden Ansprüche, wobei
- die Schaltvorrichtung (8, 10) dazu eingerichtet ist, die zweite Referenzstruktur (4b) zu einem ersten Startzeitpunkt mit dem zweiten Sensoranschluss (6b) zu verbinden;
- die Auswerteeinheit (7) dazu eingerichtet ist, das Sensorsignal zu einem ersten Messzeitpunkt mit einem vorgegebenen Grenzwert zu vergleichen, wobei zwischen dem ersten Startzeitpunkt und dem ersten Messzeitpunkt ein vorgegebenes erstes Zeitintervall liegt; und
- die Auswerteeinheit (7) dazu eingerichtet ist, die Feuchtigkeit (11) abhängig von einem Ergebnis des Vergleichs zu detektieren.

5. Elektronischer Schaltkreis (1) nach einem der vorhergehenden Ansprüche, wobei
- die Feuchtigkeitsdetektionsvorrichtung (2) eine elektrisch leitfähige weitere Detektionsstruktur (3') aufweist, die in einer Umgebung der zweiten Referenzstruktur (4b) des elektronischen Schaltkreises (1) angeordnet ist;
- die Feuchtigkeitsdetektionsvorrichtung (2) einen weiteren Spannungssensor (5') mit einem ersten weiteren Sensoranschluss, der mit der weiteren Detektionsstruktur (3') verbunden ist, und mit einem zweiten weiteren Sensoranschluss, der mit der ersten Referenzstruktur (4a) verbindbar ist, aufweist, wobei der weitere Spannungssensor (5') dazu eingerichtet ist, ein weiteres Sensorsignal abhängig von einer elektrischen Spannung zwischen dem ersten weiteren Sensoranschluss und dem zweiten weiteren Sensoranschluss zu erzeugen;
- die Schaltvorrichtung (8, 10) dazu eingerichtet ist, den zweiten weiteren Sensoranschluss wahlweise von der ersten Referenzstruktur (4a) zu trennen und mit dieser zu verbinden; und
- die Auswerteeinheit (7) dazu eingerichtet ist, abhängig von dem weiteren Sensorsignal Feuchtigkeit (11) zu detektieren, welche die zweite Referenzstruktur (4b) mit der weiteren Detektionsstruktur (3') elektrisch koppelt.

6. Elektronischer Schaltkreis (1) nach einem der Ansprüche 1 bis 4, wobei die Schaltvorrichtung (8, 10) dazu eingerichtet ist, den zweiten Sensoranschluss (6b) wahlweise von der ersten Referenzstruktur (4a) zu trennen und mit dieser zu verbinden.

7. Elektronischer Schaltkreis (1) nach Anspruch 6, wobei die Schaltvorrichtung (8, 10) dazu eingerichtet ist,
- während eines ersten Messzyklus den zweiten Sensoranschluss (6b) von der ersten Referenzstruktur (4a) zu trennen und mit der zweiten Referenzstruktur (4b) zu verbinden; und/oder
- während eines zweiten Messzyklus den zweiten Sensoranschluss (6b) von der zweiten Referenzstruktur (4b) zu trennen und mit der ersten Referenzstruktur (4a) zu verbinden.

8. Elektronischer Schaltkreis (1) nach einem der Ansprüche 6 oder 7, wobei die Auswerteeinheit (7) dazu eingerichtet ist, das Sensorsignal zu erfassen, während der zweite Sensoranschluss (6b) mit der ersten Referenzstruktur (4a) verbunden ist, um Feuchtigkeit (11) zu detektieren, welche die zweite Referenzstruktur (4b) mit der Detektionsstruktur (3) elektrisch koppelt.

9. Elektronischer Schaltkreis (1) nach einem der vorhergehenden Ansprüche, wobei die Auswerteeinheit (7) dazu eingerichtet ist, eine risikoreduzierende Maßnahme einzuleiten, wenn die Feuchtigkeit (11) detektiert wurde, welche die erste Referenzstruktur (4a) mit der Detektionsstruktur (3) elektrisch koppelt.

10. Elektronischer Schaltkreis (1) nach Anspruch 9, wobei die Auswerteeinheit (7) dazu eingerichtet ist, eine Unterbrechung einer elektrischen Verbindung des ersten Referenzpotentialanschlusses (9a) mit der ersten Referenzstruktur (4a) und/oder einer elektrischen Verbindung des zweiten Referenzpotentialanschlusses (9b) mit der zweiten Referenzstruktur (4b) einzuleiten, um die risikoreduzierende Maßnahme einzuleiten.

11. Akkupack (15) zur Versorgung eines Elektrogeräts mit elektrischer Energie, das Akkupack (15) aufweisend
- wenigstens eine Akkumulatorzelle (18) mit einer ersten Elektrode (19) und einer zweiten Elektrode (20);
- einen elektronischen Schaltkreis (1) nach einem der vorhergehenden Ansprüche, wobei der erste Referenzpotentialanschluss (9a) mit der ersten Elektrode (19) verbunden ist und der zweite Referenzpotentialanschluss (9b) mit der zweiten Elektrode (20) verbunden ist.

12. Elektrogerät mit einem elektronischen Schaltkreis (1) nach einem der Ansprüche 1 bis 10 oder mit einem Akkupack (15) nach Anspruch 11.

13. Verfahren zur Detektion von Feuchtigkeit (11) in einem elektronischen Schaltkreis (1) gemäß einem der Ansprüche 1 bis 10, wobei
- ein zweiter Sensoranschluss (6a) eines Spannungssensors (5) mit einer elektrisch leitfähigen zweiten Referenzstruktur (4b) des Schaltkreises (1) verbunden wird, wobei die zweite Referenzstruktur (4b) mit einem zweiten Referenzpotentialanschluss (9b) des Schaltkreises (1) verbunden ist;
- mittels des Spannungssensors (5) ein Sensorsignal abhängig von einer Spannung zwischen einem ersten Sensoranschluss (6a) des Spannungssensors (5), der mit einer elektrisch leitfähigen Detektionsstruktur (3) des Schaltkreises (1) verbunden ist, und dem zweiten Sensoranschluss (6b) erzeugt wird, wobei die Detektionsstruktur (3) in einer Umgebung einer elektrisch leitfähigen ersten Referenzstruktur (4a) des Schaltkreises (1) angeordnet ist; und
- abhängig von dem Sensorsignal Feuchtigkeit (11) detektiert wird, welche die erste Referenzstruktur (4a) mit der Detektionsstruktur (3) elektrisch koppelt.

14. Verfahren nach Anspruch 13, wobei
- der zweite Sensoranschluss (6b) während eines ersten Messzyklus von der ersten Referenzstruktur (4a) getrennt und mit der zweiten Referenzstruktur (4b) verbunden wird und die Feuchtigkeit (11), welche die erste Referenzstruktur (4a) mit der Detektionsstruktur (3) elektrisch koppelt, abhängig von dem während des ersten Messzyklus erfassten Sensorsignal detektiert wird;
und/oder
- der zweite Sensoranschluss (6b) während eines zweiten Messzyklus von der zweiten Referenzstruktur (4b) getrennt und mit der ersten Referenzstruktur (4a) verbunden wird und Feuchtigkeit (11), welche die zweite Referenzstruktur (4b) mit der Detektionsstruktur (3) elektrisch koppelt, abhängig von dem während des zweiten Messzyklus erfassten Sensorsignal detektiert wird.

## Claims

1. Electronic circuit (1) comprising a humidity detection device (2), the humidity detection device (2) comprising
- an electrically conductive detection structure (3) arranged in an environment of an electrically conductive first reference structure (4a) of the electronic circuit (1), wherein the first reference structure (4a) is connected to a first reference potential terminal (9a) of the electronic circuit (1);
- a voltage sensor (5) comprising a first sensor terminal (6a), which is connected to the detection structure (3), and comprising a second sensor terminal (6b), which is connectable to an electrically conductive second reference structure (4b) of the electronic circuit (1), which is connected to a second reference potential terminal (9b) of the circuit (1), wherein the voltage sensor (5) is configured to generate a sensor signal depending on an electric voltage between the first sensor terminal (6a) and the second sensor terminal (6b);
- a switching device (8, 10), which is configured to selectively disconnect the second sensor terminal (6b) from the second reference structure (4b) and connect it thereto, and
- an evaluation unit (7) configured to detect depending on the sensor signal humidity (11) which electrically couples the first reference structure (4a) to the detection structure (3).

2. Electronic circuit (1) according to claim 1, wherein the evaluation unit (7) is configured to capture the sensor signal, while the second sensor terminal (6b) is connected to the second reference structure (4b) in order to detect the humidity (11).

3. Electronic circuit (1) according to any one of the preceding claims, wherein the evaluation unit (7) is configured to capture a temporal course of the sensor signal, while the second sensor terminal (6b) is connected to the second reference structure (4b), and to detect the humidity (11) depending on the temporal course.

4. Electronic circuit (1) according to any one of the preceding claims, wherein
- the switching device (8, 10) is configured to connect the second reference structure (4b) to the second sensor terminal (6b) at a first starting time;
- the evaluation unit (7) is configured to compare the sensor signal with a predetermined threshold value at a first measurement time point, wherein a predetermined first time interval lies between the first starting time and the first measurement time point; and
- the evaluation unit (7) is configured to detect the humidity (11) depending on a result of the comparison.

5. Electronic circuit (1) according to any one of the preceding claims, wherein
- the humidity detection device (2) comprises an electrically conductive further detection structure (3'), which is arranged in an environment of the second reference structure (4b) of the electronic circuit (1);
- the humidity detection device (2) comprises a further voltage sensor (5') comprising a first further sensor terminal, which is connected to the further detection structure (3'), and comprising a second further sensor terminal, which is connectable to the first reference structure (4a), wherein the further voltage sensor (5') is configured to generate a further sensor signal depending on an electric voltage between the first further sensor terminal and the second further sensor terminal;
- the switching device (8, 10) is configured to selectively disconnect the second further sensor terminal from the first reference structure (4a) and connect it thereto; and
- the evaluation unit (7) is configured to detect depending on the further sensor signal humidity (11) which electrically couples the second reference structure (4b) to the further detection structure (3').

6. Electronic circuit (1) according to any one of claims 1 to 4, wherein the switching device (8, 10) is configured to selectively disconnect the second sensor terminal (6b) from the first reference structure (4a) and connect it thereto.

7. Electronic circuit (1) according to claim 6, wherein the switching device (8, 10) is configured
- to disconnect the second sensor terminal (6b) from the first reference structure (4a) and connect it to the second reference structure (4b) during a first measuring cycle; and/or
- to disconnect the second sensor terminal (6b) from the second reference structure (4b) and connect it to the first reference structure (4a) during a second measuring cycle.

8. Electronic circuit (1) according to any one of claims 6 or 7, wherein the evaluation unit (7) is configured to capture the sensor signal, while the second sensor terminal (6b) is connected to the first reference structure (4a) in order to detect humidity (11), which electrically couples the second reference structure (4b) to the detection structure (3).

9. Electronic circuit (1) according to any one of the preceding claims, wherein the evaluation unit (7) is configured to initiate a risk-reducing measure if the humidity (11), which electrically couples the first reference structure (4a) to the detection structure (3), was detected.

10. Electronic circuit (1) according to claim 9, wherein the evaluation unit (7) is configured to initiate an interruption of an electric connection of the first reference potential terminal (9a) to the first reference structure (4a) and/or an electric connection of the second reference potential terminal (9b) to the second reference structure (4b) in order to initiate the risk-reducing measure.

11. Battery pack (15) for supplying an electric appliance with electric energy, the battery pack (15) comprising
- at least one accumulator cell (18) comprising a first electrode (19) and a second electrode (20);
- an electronic circuit (1) according to any one of the preceding claims, wherein the first reference potential terminal (9a) is connected to the first electrode (19) and the second reference potential terminal (9b) is connected to the second electrode (20).

12. Electric appliance comprising an electronic circuit (1) according to any one of claims 1 to 10 or comprising a battery pack (15) according to claim 11.

13. Method for detecting humidity (11) in an electronic circuit (1) according to any one of claims 1 to 10, wherein
- a second sensor terminal (6a) of a voltage sensor (5) is connected to an electrically conductive second reference structure (4b) of the circuit (1), wherein the second reference structure (4b) is connected to a second reference potential terminal (9b) of the circuit (1):
- by the voltage sensor (5) a sensor signal depending on a voltage between a first sensor terminal (6a) of the voltage sensor (5), which is connected to an electrically conductive detection structure (3) of the circuit (1), and the second sensor terminal (6b) is generated, wherein the detection structure (3) is arranged in an environment of an electrically conductive first reference structure (4a) of the circuit (1); and
- depending on the sensor signal humidity (11), which electrically couples the first reference structure (4a) to the detection structure (3), is detected.

14. Method according to claim 13, wherein
- the second sensor terminal (6b) during a first measuring cycle is disconnected from the first reference structure (4a) and connected to the second reference structure (4b) and the humidity (11), which electrically couples the first reference structure (4a) to the detection structure (3), is detected depending on the sensor signal captured during the first measuring cycle;
and/or
- the second sensor terminal (6b) during a second measuring cycle is disconnected from the second reference structure (4b) and connected to the first reference structure (4a) and humidity (11), which electrically couples the reference structure (4b) to the detection structure (3), is detected depending on the sensor signal captured during the second measuring cycle.

## Revendications

1. Circuit électronique (1) avec un dispositif de détection d'humidité (2), le dispositif de détection d'humidité (2) comprenant
- une structure de détection (3) électriquement conductrice, qui est disposée dans un environnement d'une première structure de référence (4a) électriquement conductrice du circuit électronique (1), la première structure de référence (4a) étant connectée à une première borne de potentiel de référence (9a) du circuit électronique (1) ;
- un capteur de tension (5) doté d'une première borne de capteur (6a) connectée à la structure de détection (3) et d'une deuxième borne de capteur (6b) qui peut être connectée à une deuxième structure de référence (4b) électriquement conductrice du circuit électronique (1), qui est connectée à une deuxième borne de potentiel de référence (9b) du circuit (1), le capteur de tension (5) étant conçu pour générer un signal de capteur en fonction d'une tension électrique entre la première borne de capteur (6a) et la deuxième borne de capteur (6b) ;
- un dispositif de commutation (8, 10), qui est conçu pour, sélectivement, déconnecter la deuxième borne de capteur (6b) de la deuxième structure de référence (4b) et la connecter à celle-ci, et
- une unité d'évaluation (7), qui est conçue pour détecter l'humidité (11) en fonction du signal de capteur, laquelle couple électriquement la première structure de référence (4a) à la structure de détection (3).

2. Circuit électronique (1) selon la revendication 1, l'unité d'évaluation (7) étant conçue pour acquérir le signal de capteur, tandis que la deuxième borne de capteur (6b) est connectée à la deuxième structure de référence (4b) afin de détecter l'humidité (11).

3. Circuit électronique (1) selon l'une des revendications précédentes, l'unité d'évaluation (7) étant conçue pour acquérir une évolution temporelle du signal de capteur, tandis que la deuxième borne de capteur (6b) est connectée à la deuxième structure de référence (4b), et pour détecter l'humidité (11) en fonction de l'évolution temporelle.

4. Circuit électronique (1) selon l'une des revendications précédentes,
- le dispositif de commutation (8, 10) étant conçu pour connecter la deuxième structure de référence (4b) à la deuxième borne de capteur (6b) à un premier instant de départ ;
- l'unité d'évaluation (7) étant conçue pour comparer le signal de capteur à un premier instant de mesure avec une valeur limite prédéfinie, un premier intervalle de temps prédéfini étant compris entre le premier instant de départ et le premier instant de mesure ; et
- l'unité d'évaluation (7) étant conçue pour détecter l'humidité (11) en fonction d'un résultat de la comparaison.

5. Circuit électronique (1) selon l'une des revendications précédentes,
- le dispositif de détection d'humidité (2) possédant une structure de détection supplémentaire (3') électriquement conductrice qui est disposée dans un environnement de la deuxième structure de référence (4b) du circuit électronique (1) ;
- le dispositif de détection d'humidité (2) possédant un capteur de tension supplémentaire (5') ayant une première borne supplémentaire de capteur, qui est connectée à la structure de détection supplémentaire (3'), et une deuxième borne supplémentaire de capteur, qui peut être connectée à la première structure de référence (4a), le capteur de tension supplémentaire (5') étant conçu pour générer un signal de capteur supplémentaire en fonction d'une tension électrique entre la première borne supplémentaire de capteur et la deuxième borne supplémentaire de capteur ;
- le dispositif de commutation (8, 10) étant conçu pour, sélectivement, déconnecter la deuxième borne supplémentaire de capteur de la première structure de référence (4a) et la connecter à celle-ci ; et
- l'unité d'évaluation (7) étant conçue pour détecter l'humidité (11) en fonction du signal de capteur supplémentaire, laquelle couple électriquement la deuxième structure de référence (4b) à la structure de détection supplémentaire (3').

6. Circuit électronique (1) selon l'une des revendications 1 à 4, le dispositif de commutation (8, 10) étant conçu pour, sélectivement, déconnecter la deuxième borne de capteur (6b) de la première structure de référence (4a) et la connecter à celle-ci.

7. Circuit électronique (1) selon la revendication 6, le dispositif de commutation (8, 10) étant conçu pour,
- pendant un premier cycle de mesure, déconnecter la deuxième borne de capteur (6b) de la première structure de référence (4a) et la connecter à la deuxième structure de référence (4b) ; et/ou
- pendant un deuxième cycle de mesure, déconnecter la deuxième borne de capteur (6b) de la deuxième structure de référence (4b) et la connecter à la première structure de référence (4a).

8. Circuit électronique (1) selon l'une des revendications 6 ou 7, l'unité d'évaluation (7) étant conçue pour acquérir le signal de capteur, tandis que la deuxième borne de capteur (6b) est connectée à la première structure de référence (4a) pour détecter l'humidité (11), laquelle couple électriquement la deuxième structure de référence (4b) à la structure de détection (3).

9. Circuit électronique (1) selon l'une des revendications précédentes, l'unité d'évaluation (7) étant conçue pour initier une mesure de réduction des risques lorsque l'humidité (11) qui couple électriquement la première structure de référence (4a) à la structure de détection (3) a été détectée.

10. Circuit électronique (1) selon la revendication 9, l'unité d'évaluation (7) étant conçue pour initier une interruption d'une connexion électrique de la première borne de potentiel de référence (9a) avec la première structure de référence (4a) et/ou d'une connexion électrique de la deuxième borne de potentiel de référence (9b) avec la deuxième structure de référence (4b) afin d'initier la mesure de réduction des risques.

11. Bloc-batterie (15) destiné à alimenter un appareil électrique en énergie électrique, le bloc-batterie (15) possédant
- au moins une cellule de batterie (18) dotée d'une première électrode (19) et d'une deuxième électrode (20) ;
- un circuit électronique (1) selon l'une des revendications précédentes, la première borne de potentiel de référence (9a) étant connectée à la première électrode (19) et la deuxième borne de potentiel de référence (9b) étant connectée à la deuxième électrode (20).

12. Appareil électrique comportant un circuit électronique (1) selon l'une des revendications 1 à 10 ou comprenant un bloc-batterie (15) selon la revendication 11.

13. Procédé de détection d'humidité (11) dans un circuit électronique (1) selon l'une quelconque des revendications 1 à 10,
- une deuxième borne de capteur (6a) d'un capteur de tension (5) étant connectée à une deuxième structure de référence (4b) électriquement conductrice du circuit (1), la deuxième structure de référence (4b) étant connectée à une deuxième borne de potentiel de référence (9b) du circuit (1) ;
- un signal de capteur étant généré au moyen du capteur de tension (5) en fonction d'une tension entre une première borne de capteur (6a) du capteur de tension (5), qui est connectée à une structure de détection (3) électriquement conductrice du circuit (1), et la deuxième borne de capteur (6b), la structure de détection (3) étant disposée dans un environnement d'une première structure de référence (4a) électriquement conductrice électriquement conductrice du circuit (1) ; et
- de l'humidité (11) étant détectée en fonction du signal de capteur, laquelle couple électriquement la première structure de référence (4a) à la structure de détection (3).

14. Procédé selon la revendication 13,
- la deuxième borne de capteur (6b), pendant un premier cycle de mesure, étant déconnectée de la première structure de référence (4a) et étant connectée à la deuxième structure de référence (4b), et l'humidité (11) qui couple électriquement la première structure de référence (4a) à la structure de détection (3) étant détectée en fonction du signal de capteur acquis pendant le premier cycle de mesure ; et/ou
- la deuxième borne de capteur (6b), pendant un deuxième cycle de mesure, étant déconnectée de la deuxième structure de référence (4b) et étant connectée à la première structure de référence (4a), et l'humidité (11) qui couple électriquement la deuxième structure de référence (4b) à la structure de détection (3) étant détectée en fonction du signal de capteur acquis pendant le deuxième cycle de mesure.
